# EUROPEAN PATENT SPECIFICATION

(11) **EP 4 203 316 B1**
(45) Date of publication and mention of the grant of the patent: **01.10.2025**
(21) Application number: 21929829.6
(22) Date of filing: 19.08.2021
(51) Int. Cl.: H03K 17/28, H03K 5/1534

(54) **SIGNAL OUTPUT CIRCUIT AND DELAY SIGNAL OUTPUT CIRCUIT**
SIGNALAUSGABESCHALTUNG UND VERZÖGERUNGSSIGNALAUSGABESCHALTUNG
CIRCUIT DE SORTIE DE SIGNAL ET CIRCUIT DE SORTIE DE SIGNAL DE RETARD

(30) Priority: 09.03.2021 CN 202110256939
(43) Date of publication of application: 28.06.2023
(73) Proprietor: Changxin Memory Technologies, Inc., Hefei, Anhui 230601 (CN)
(72) Inventor: WANG, Jia, Hefei, Anhui 230601 (CN)
(74) Representative: Gulde & Partner
(86) International application number: PCT/CN2021/113618
(87) International publication number: WO 2022/188363

(56) References cited:
- CN-A- 1 716 776
- CN-A- 102 215 037
- CN-A- 102 769 458
- CN-U- 202 357 595
- JP-B2- 5 058 295
- KR-A- 20070 044 667
- US-A1- 2005 189 977

## Description

### TECHNICAL FIELD

Embodiments of the disclosure relate to, but are not limited to, a signal output circuit and a circuit for outputting a delayed signal.

### BACKGROUND

During the design of semiconductor circuits, stagger signals that are equally spaced are often used, and the stagger signals that are equally spaced may refer to the signal generated with a fixed delay in each interval.

For a synchronous signal, a clock signal is usually used to generate the stagger signals that are equally spaced; for an asynchronous signal, a delay unit is inserted to generate the stagger signals that are equally spaced. A delay between the signals can be achieved by inserting the corresponding delay unit according to requirements. The synchronous signal is used to generate the stagger signals that are equally spaced, the delay between the stagger signals that are equally spaced must be an integer multiple of a clock period, and the controllability of the delay between the stagger signals that are equally spaced is poor. The asynchronous signal is also used to generate the stagger signals that are equally spaced. In this way, although the delay between the signals may be well controllable, the area of the formed circuit layout and the power consumption of the circuit will be significantly increased.

Related arts can be found in KR20070044667A and US2005/189977A1.

### SUMMARY

Embodiments of the disclosure provide a signal output circuit and a circuit for outputting a delayed signal, which are configured to generate a delayed signal with a controllable delay according to a first pulse signal and a second pulse signal. And the area of the circuit layout will be smaller, and the power consumption of the circuit will be lower.

Embodiments of the disclosure provide a circuit for outputting a delayed signal, comprising G signal output circuits, where G is an integer greater than or equal to 2; wherein each stage of the signal output circuits is configured to receive a delayed output signal output by a previous-stage signal output circuit and generate a delayed output signal of a current-stage signal output circuit according to a first pulse signal, a second pulse signal and the delayed output signal output by the previous-stage signal output circuit; wherein each of non-first-stage signal output circuits is configured to receive the delayed output signal output by the previous-stage signal output circuit as an input signal of a respective one of the non-first-stage signal output circuits; and a first-stage signal output circuit is configured to receive an initial input signal as an input signal of the first-stage signal output circuit; wherein a rising edge of the delayed output signal generated by each of the signal output circuits has a first delay relative to a rising edge of the received delayed output signal output by the previous-stage signal output circuit; and wherein a falling edge of the delayed output signal generated by each of the signal output circuits has a second delay relative to a falling edge of the revived delayed output signal output by the previous-stage signal output circuit; wherein the signal output circuit, comprising:a first control module, configured to receive a first pulse signal and an input signal, and output a first adjustment signal, wherein a first preset edge of the first adjustment signal has a first delay relative to a rising edge of the input signal, the first delay being a pulse period of the first pulse signal; a second control module, configured to receive a second pulse signal and the input signal, and output a second adjustment signal, wherein a second preset edge of the second adjustment signal has a second delay relative to a falling edge of the input signal, the second delay being a pulse period of the second pulse signal; and a signal output module, configured to receive the first adjustment signal and the second adjustment signal, and output a delayed output signal, a rising edge of the delayed output signal is generated according to the first preset edge of the first adjustment signal, and a falling edge of the delayed output signal is generated according to the second preset edge of the second adjustment signal; wherein the signal output module comprises: a first receiving unit, configured to receive the first pulse signal and the first adjustment signal, and generate a first pulse control signal when the first adjustment signal is at an active level, wherein a pulse phase of first pulse control signal is opposite to a pulse phase of the first pulse signal; a second receiving unit, configured to receive the second pulse signal and the second adjustment signal, and generate a second pulse control signal when the second adjustment signal is at an active level, wherein a pulse phase of the second pulse control signal is opposite to a pulse phase of the second pulse signal; and a latch unit, configured to receive the first pulse control signal and the second pulse control signal, and generate the delayed output signal.

### BRIEF DESCRIPTION OF THE DRAWINGS

FIG. 1 illustrates a schematic structural diagram of a signal output circuit according to an embodiment of the disclosure.
FIG. 2 illustrates a schematic diagram of a specific circuit in a first control module according to an embodiment of the disclosure.
FIG. 3 illustrates a schematic diagram of a specific circuit in a second control module according to an embodiment of the disclosure.
FIG. 4 illustrates a schematic structural diagram of a signal output module according to an embodiment of the disclosure.
FIGS. 5 and 6 illustrate schematic diagrams of specific circuits in a signal output module according to an embodiment of the disclosure.
FIG. 7 illustrates a schematic diagram of a time sequence of signals in a signal output circuit according to an embodiment of the disclosure.
FIGS. 8 and 9 illustrate schematic structural diagrams of a circuit for outputting a delayed signal according to an embodiment of the disclosure.
FIG. 10 illustrates a schematic diagram of a specific circuit of a circuit for outputting a delayed signal according to an embodiment of the disclosure.
FIG. 11 illustrates a schematic diagram of a specific circuit of a signal output circuit in a circuit for outputting a delayed signal according to an embodiment of the disclosure.
FIG. 12 illustrates a schematic diagram of a time sequence of signals in a circuit for outputting a delayed signal according to an embodiment of the disclosure.

### DETAILED DESCRIPTION

In the art, the synchronous signal is used to generate the stagger signals that are equally spaced, the delay between the stagger signals that are equally spaced must be an integer multiple of the clock period, and the controllability of the delay between the stagger signals that are equally spaced is poor. The asynchronous signal is also used to generate the stagger signals that are equally spaced. In this way, although the delay between the signals may be well controllable, the area of the formed circuit layout and the power consumption of the circuit will be significantly increased.

However, the area of the circuit layout and the power consumption of the circuit can be reduced by adjusting the signal delay between the stagger signals that are equally spaced through the period of the pulse signal, and the delay between the signals does not need to be an integer multiple of the clock period. Thus, how to generate a delayed output signal according to a pulse signal will be a prerequisite for optimizing the generation of the stagger signals that are equally spaced.

The embodiments of the disclosure provide a circuit for outputting a delayed signal, comprising G signal output circuits, where G is an integer greater than or equal to 2; wherein each stage of the signal output circuits is configured to receive a delayed output signal output by a previous-stage signal output circuit and generate a delayed output signal of a current-stage signal output circuit according to a first pulse signal, a second pulse signal and the delayed output signal output by the previous-stage signal output circuit; wherein each of non-first-stage signal output circuits is configured to receive the delayed output signal output by the previous-stage signal output circuit as an input signal of a respective one of the non-first-stage signal output circuits; and a first-stage signal output circuit is configured to receive an initial input signal as an input signal of the first-stage signal output circuit; wherein a rising edge of the delayed output signal generated by each of the signal output circuits has a first delay relative to a rising edge of the received delayed output signal output by the previous-stage signal output circuit; and wherein a falling edge of the delayed output signal generated by each of the signal output circuits has a second delay relative to a falling edge of the revived delayed output signal output by the previous-stage signal output circuit; wherein the signal output circuit, comprising:a first control module, configured to receive a first pulse signal and an input signal, and output a first adjustment signal, wherein a first preset edge of the first adjustment signal has a first delay relative to a rising edge of the input signal, the first delay being a pulse period of the first pulse signal; a second control module, configured to receive a second pulse signal and the input signal, and output a second adjustment signal, wherein a second preset edge of the second adjustment signal has a second delay relative to a falling edge of the input signal, the second delay being a pulse period of the second pulse signal; and a signal output module, configured to receive the first adjustment signal and the second adjustment signal, and output a delayed output signal, a rising edge of the delayed output signal is generated according to the first preset edge of the first adjustment signal, and a falling edge of the delayed output signal is generated according to the second preset edge of the second adjustment signal; wherein the signal output module comprises: a first receiving unit, configured to receive the first pulse signal and the first adjustment signal, and generate a first pulse control signal when the first adjustment signal is at an active level, wherein a pulse phase of first pulse control signal is opposite to a pulse phase of the first pulse signal; a second receiving unit, configured to receive the second pulse signal and the second adjustment signal, and generate a second pulse control signal when the second adjustment signal is at an active level, wherein a pulse phase of the second pulse control signal is opposite to a pulse phase of the second pulse signal; and a latch unit, configured to receive the first pulse control signal and the second pulse control signal, and generate the delayed output signal.

In order to make the objectives, technical solutions, and advantages of the embodiments of the disclosure clearer, the various embodiments of the disclosure will be described in detail below with reference to the accompanying drawings. However, those of ordinary skill in the art can understand that, in each embodiment of the disclosure, many technical details are proposed for the reader to better understand the disclosure. However, even without these technical details as well as various changes and modifications according to the following embodiments, the technical solution claimed in the disclosure can be realized. The following divisions of the various embodiments are for convenience of description, and should not constitute any limitation on the specific implementation manners of the disclosure, and the various embodiments may be combined with each other under the premise of no contradiction.

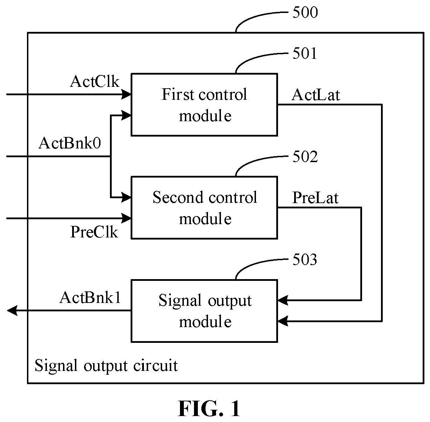

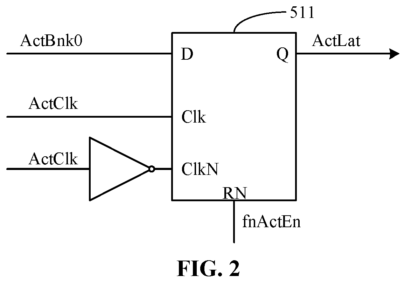

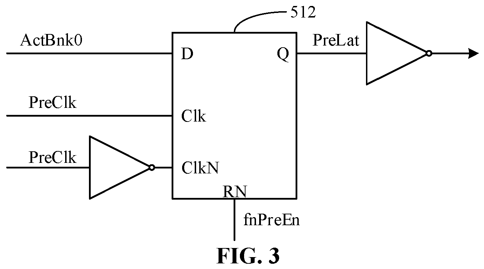

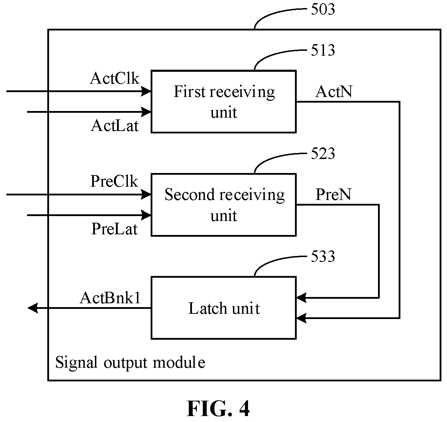

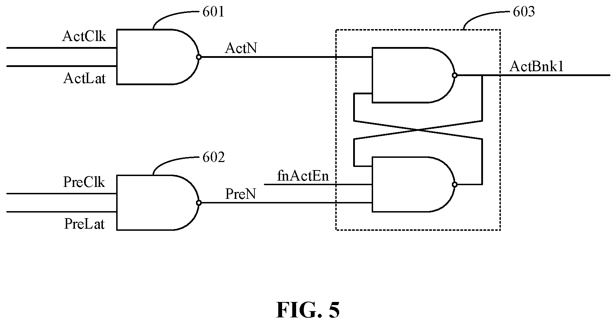

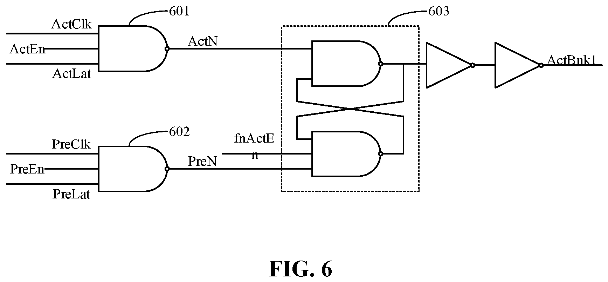

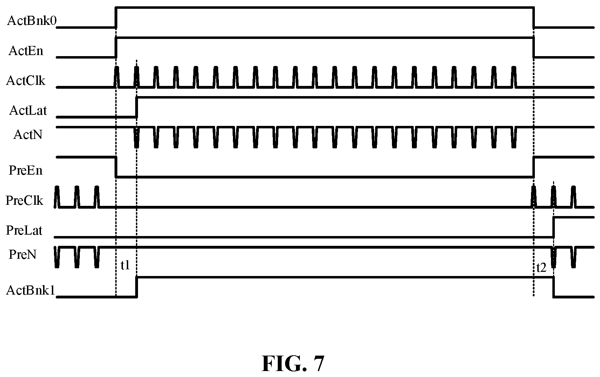

FIG. 1 illustrates a schematic structural diagram of a signal output circuit according to an embodiment of the disclosure, FIG. 2 illustrates a schematic diagram of a specific circuit in a first control module according to an embodiment of the disclosure, FIG. 3 illustrates a schematic diagram of a specific circuit in a second control module according to an embodiment of the disclosure, FIG. 4 illustrates a schematic structural diagram of a signal output module according to an embodiment of the disclosure, FIGS. 5 and 6 illustrate schematic diagrams of specific circuits in a signal output module according to an embodiment of the disclosure, FIG. 7 illustrates a schematic diagram of a time sequence of signals in a signal output circuit according to an embodiment of the disclosure. The signal output circuit according to the embodiments of the disclosure will be further described in detail below in combination with the accompanying drawings.

Referring to FIG. 1, a circuit 500 for outputting a signal includes a first control module 501 configured to receive a first pulse signal ActClk and an input signal ActBnk0, and output a first adjustment signal ActLat, where a first preset edge of the first adjustment signal has a first delay relative to a rising edge of the input signal ActBnk0, the first delay being a pulse period of the first pulse signal ActClk.

In some embodiments of the disclosure, the rising edge or falling edge of the first pulse signal ActClk may be used to sample the input signal ActBnk0, and then the first adjustment signal ActLat may be output; or after detecting the rising edge or falling edge of the first pulse signal ActClk, the output of the input signal ActBnk0 may be delayed so as to acquire the first adjustment signal ActLat.

In the embodiments of the disclosure, the first preset edge may be the rising edge as an example for illustration. The input signal ActBnk0 may be an external input signal (compared to the signal output circuit 500), and the signal output circuit 500 may be configured to generate a delayed output signal ActBnk1 according to the input signal ActBnk0. A rising edge of the delayed output signal ActBnk1 may be generated according to the rising edge of the first adjustment signal ActLat, and there may be the first delay between the rising edge of the first adjustment signal ActLat and the rising edge of the input signal ActBnk0. That is, the rising edge of the delayed output signal ActBnk1 may have a first delay relative to the rising edge of the input signal ActBnk0, and the first delay may be a pulse period of the first pulse signal ActClk. Therefore, it can be seen that the first pulse signal ActClk input externally may be configured to adjust the delay of the rising edge of the delayed output signal ActBnk1. It should be noted that, in some embodiments of the disclosure, the first preset edge may also be a falling edge.

It should be noted that, in the description of "the rising edge of the delayed output signal ActBnk1 may be generated according to the first preset edge of the first adjustment signal ActLat", the meaning of "according to" may include but is not limited to: the rising edge of the delayed output signal ActBnk1 may be generated in response to detecting the first preset edge of the first adjustment signal ActLat; or the rising edge of the delayed output signal ActBnk1 may be generated, after detecting that the first adjustment signal ActLat changes from a low level to a high level (or changing from the high level to the low level).

In some embodiments of the disclosure referring to FIG. 2, the first control module 501 may include a first D-trigger 511, where a clock terminal of the first D-trigger 511 may be configured to receive the first pulse signal ActClk, a reset terminal of the first D-trigger 511 may be configured to receive a first reset signal fnActEn, an input terminal of the first D-trigger 511 may be configured to receive the input signal ActBnk0, and an output terminal of the first D-trigger 511 may be configured to output the first adjustment signal ActLat.

Continuing to refer to FIG. 1, the signal output circuit 500 further includes a second control module 502, configured to receive a second pulse signal PreClk and the input signal ActBnk0, and output a second adjustment signal PreLat, where a second preset edge of the second adjustment signal PreLat has a second delay relative to the falling edge of the input signal ActBnk0, the second delay being a pulse period of the second pulse signal PreClk.

In the embodiments of the disclosure, the second preset edge may be the rising edge as an example for illustration. The falling edge of the delayed output signal ActBnk1 may be generated according to the rising edge of the second adjustment signal PreLat, and there may be a second delay between the rising edge of the second adjustment signal PreLat and the falling edge of the input signal ActBnk0. That is, the falling edge of the delayed output signal ActBnk1 may have the second delay relative to the falling edge of the input signal ActBnk0, and the second delay may be a pulse period of the second pulse signal PreClk. Therefore, it can be seen that the second pulse signal PreClk input externally may be configured to adjust the delay of the falling edge of the delayed output signal ActBnk1. It should be noted that in some embodiments of the disclosure, the second preset edge may also be a falling edge.

It should be noted that, in the description of "the falling edge of the delayed output signal ActBnk1 may be generated according to the second preset edge of the second adjustment signal PreLat", the meaning of "according to" may include but is not limited to: the falling edge of the delayed output signal ActBnk1 may be generated in response to detecting the second preset edge of the second adjustment signal PreLat; or the falling edge of the delayed output signal ActBnk1 may be generated, after detecting that the second adjustment signal PreLat changes from a low level to a high level (or changing from the high level to the low level).

In some embodiments of the disclosure, referring to FIG. 3, the second control module 502 may include a second D-trigger 512, where a clock terminal of the first D-trigger 512 may be configured to receive the second pulse signal PreClk, a reset terminal of the first D-trigger 512 may be configured to receive a second reset signal fnPreEn, an input terminal of the first D-trigger 512 may be configured to receive the input signal ActBnk0, and an output terminal of the first D-trigger 512 may be serially connected with an inverter and configured to output the second adjustment signal at an output of the inverter.

In the embodiments of the disclosure, the pulse period of the first pulse signal ActClk may be equal to the pulse period of the second pulse signal PreClk, and the delay degree of the rising edge of the first adjustment signal ActLat may be the same as the delay degree of the rising edge of the second adjustment signal PreLat. In some embodiments of the disclosure, the pulse period of the first pulse signal and the pulse period of the second pulse signal may be different.

In addition, in the embodiments of the disclosure, one pulse of the first pulse signal ActClk may be aligned with the rising edge of the input signal ActBnk0, and one pulse of the second pulse signal PreClk may be aligned with the falling edge of the input signal ActBnk0. It should be noted that the "be aligned" described here may not be necessarily perfect alignment under ideal conditions, and may include subtle differences in the rising/falling edges caused by factors such as circuit delays. One pulse of the first pulse signal ActClk may be aligned with the rising edge of the input signal ActBnk0, to ensure the accuracy of the first delay between the first signal edge of the first adjustment signal ActLat and the rising edge of the input signal ActBnk0. One pulse of the second pulse signal PreClk may be aligned with the falling edge of the input signal ActBnk0, to ensure the accuracy of the second delay between the second signal edge of the second adjustment signal PreLat and the falling edge of the input signal ActBnk0. Continuing to refer to FIG. 1, the signal output circuit 500 further includes: a signal output module 503, configured to receive the first adjustment signal ActLat and the second adjustment signal PreLat, and output the delayed output signal ActBnk1, where the rising edge of the delayed output signal ActBnk1 is generated according to the first preset edge of the first adjustment signal ActLat, and the falling edge of the delayed output signal ActBnk1 is generated according to the second preset edge of the second adjustment signal PreLat.

In some embodiments of the disclosure, referring to FIG. 4, the signal output module 503 may include: a first receiving unit 513, a second receiving unit 523 and a latch unit 533. The first receiving unit 513 may be configured to receive the first pulse signal ActClk and the first adjustment signal ActLat, and generate a first pulse control signal ActN when the first adjustment signal ActLat is at an active level, where a pulse phase of the first pulse control signal ActN may be the same as a pulse phase of the first pulse signal ActClk. The second receiving unit 523 may be configured to receive the second pulse signal PreClk and the second adjustment signal PreLat, and generate a second pulse control signal PreN when the second adjustment signal PreLat is at an active level, and a pulse phase of the second pulse control signal PreN may be the same as a pulse phase of the second pulse signal PreClk. And the latch unit 533 may be configured to receive the first pulse control signal ActN and the second pulse control signal PreN, and generate the delayed output signal ActLat.

In some embodiments of the disclosure, when the first adjustment signal ActLat is determined as an active level, the first pulse control signal ActN may be generated by the first pulse signal ActClk according to the inverter. When the second adjustment signal PreLat is detected as an active level, the second pulse control signal PreN may be generated by the second pulse signal PreClk according the inverter.

In some embodiments of the disclosure, referring to FIG. 5, the first receiving unit 513 may include a first receiving NAND gate 601, and the first receiving NAND gate 601 may include a first input terminal that is configured to receive the first adjustment signal ActLat, a second input terminal that is configured to receive the first pulse signal ActClk, and a first output terminal that is configured to output the first pulse control signal ActN. The second receiving unit 523 may include a second receiving NAND gate 602, and the second receiving NAND 602 may include a third input terminal that is configured to receive the second adjustment signal PreLat, a fourth input terminal that is configured to receive the second pulse signal PreClk, and a second output terminal that is configured to output the second pulse control signal PreN. The latch unit 533 may include a latch, and the latch may include a fifth input terminal that is configured to receive the first pulse control signal ActN, a sixth input terminal that is configured to receive the second pulse control signal PreN, and a third output terminal that is configured to output the delayed output signal ActBnk1.

The latch unit 603 may be configured such that: the delayed output signal ActBnk1 and the second pulse control signal PreN may be both at a same level, when the first pulse control signal ActN and the second pulse control signal PreN are at different levels; and the latch unit 603 may maintain a state, when the first pulse control signal ActN and the second pulse control signal PreN may be both at high levels.

In the embodiments of the disclosure, when the first pulse signal ActN and the second pulse control signal PreN are both at high levels, the latch unit 603 may maintain the state; when the first pulse control signal ActN is at the high level and the second pulse signal control signal PreN is at a low level, the latch unit 603 may output the low level; and when the first pulse control signal ActN is at the low level and the second pulse signal control signal PreN is at the high level, the latch unit 603 may output the high level.

In some embodiments of the disclosure, the first receiving unit 513 may further be configured to receive a first control signal ActEn, and generate the first pulse control signal ActN according to the first pulse signal ActClk when the first adjustment signal ActLat and the first control signal ActEn are both at active levels. The second receiving unit 523 may further be configured to receive a second control signal PreEn, and generate the second pulse control signal PreN according to the second pulse signal PreClk when the second adjustment signal PreLat and the second control signal PreEn may be both at active levels.

Referring to FIG. 6, the first receiving NAND gate 601 may further be configured to receive a first control signal ActEn, and generate the first pulse control signal ActN according to the first clock signal ActClk, the first control signal ActEn, and the first adjustment signal ActLat. The second receiving NAND gate 602 may further be configured to receive a second control signal PreEn, and generate the second pulse control signal PreN according to the second clock signal PreClk, the second control signal PreEn, and the second adjustment signal PreLat. The first control signal ActEn and the second control signal PreEn may be both inverted signals, the first pulse signal ActClk may exist when the first control signal ActEn is at an active level, and the second pulse signal PreClk may exist when the second control signal PreEn is at an active level. The first control signal ActEn and the second control signal PreEn may be respectively received by the first receiving NAND gate 601 and the second receiving NAND gate 602, to ensure the stability of the output of the first receiving NAND gate 601 and the second receiving NAND gate 602.

In some embodiments of the disclosure, the first pulse signal ActClk and the second pulse signal PreClk may be staggered with each other, and the staggered pulse signals may be pulse signals generated according to the inverted signals. In the embodiments of the disclosure, the first pulse signal ActClk may exist when the first control signal ActEn is at an active level, and the initial pulse of the first pulse signal ActClk may be aligned with the rising edge of the first control signal ActEn. The second pulse signal PreClk may exist when the second control signal PreEn is at an active level, and the initial pulse of the second pulse signal PreClk may be aligned with the rising edge of the second control signal PreEn. It should be noted that the "be aligned" described here may not be necessarily perfect alignment under ideal conditions, and may include subtle differences in the rising/falling edges due to factors such as the circuit delays.

In some embodiments of the disclosure, referring to FIG. 7, the input signal ActBnk0, the first pulse signal ActClk, and the second pulse signal PreClk may be external input signals. And assuming that the period of the first pulse signal ActClk is t1, the period of the second pulse signal PreClk may be t2. With reference to FIG. 2, the first adjustment signal ActLat may be generated according to the input signal ActBnk0 and the first pulse signal ActClk, and when the first pulse signal ActClk is at the high level, the secondary state of the first adjustment signal ActLat may be the current state of the input signal ActBnk0. Therefore, there may be the first delay between the rising edge of the first adjustment signal ActLat and the rising edge of the input signal ActBnk0, and the first delay may be the period of the first pulse signal ActClk; that is, the delay between the rising edge of the first adjustment signal ActLat and the rising edge of the input signal ActBnk0 may be t1. Referring to FIG. 3, the second adjustment signal PreLat may be generated according to the input signal ActBnk0 and the second pulse signal PreClk; and when the second pulse signal PreClk may be at the high level, the secondary state of the second adjustment signal PreLat may be the current state of the input signal ActBnk0. Therefore, there may be the second delay between the rising edge of the second adjustment signal PreLat and the falling edge of the input signal ActBnk0, and the second delay may be the period of the second pulse signal PreClk; that is, the delay between the rising edge of the second adjustment signal PreLat and the falling edge of the input signal ActBnk0 may be t2. Referring to FIG. 6, in order to ensure the stability of the output of the first receiving NAND gate 601 and the second receiving NAND gate 602, the first receiving NAND gate 601 may further be configured to receive the first control signal ActEn, and the second receiving NAND gate 602 may further be configured to receive the second control signal PreEn, where the first control signal ActEn and the second control signal PreEn may be inverted signals. At this time, the first receiving NAND gate 601 and the second receiving NAND gate 602 may be configured to respectively generate the first pulse control signal ActN and the second pulse control signal PreN. The latch unit 603 may be configured to generate the delayed output signal ActBnk1 according to the first pulse control signal ActN and the second pulse control signal PreN. There may be the first delay between the rising edge of the delayed output signal ActBnk1 and the rising edge of the input signal ActBnk0, and the first delay is the pulse period t1 of the first pulse signal ActClk. And there may be the second delay between the falling edge of the delayed output signal ActBnk1 and the falling edge of the input signal ActBnk0, and the second delay may be the pulse period t2 of the second pulse signal PreClk. In the embodiments of the disclosure, the pulse period of the first pulse signal ActClk may be equal to the pulse period of the second pulse signal PreClk, that is, the signal changing edge of the delayed output signal ActBnk1 may have an equal time delay relative to the signal changing edge of the input signal ActBnk0. It should be noted that the diagram of the time sequence of each signal shown in FIG. 7 may be only used to interpret the circuit function of the signal output circuit 500 according to the embodiments of the disclosure, and does not constitute a limitation to the embodiments of the disclosure. In some embodiments of the disclosure, the corresponding delay input signal may be generated according to other input signals; in addition, the input signal may also be inconsistent with the first control signal.

It should be noted that in some embodiments of the disclosure, the signal output circuit may further include an even number of inverters, and the inverters may be serially connected with an output terminal of the signal output module, so as to enhance the driving capability of the signal output circuit.

It should be understood that the delayed output signal with a controllable delay may be generated according to the first pulse signal and the second pulse signal. Compared with the input signal, the delayed output signal may have the first delay on the rising edge and the second delay on the falling edge; the first delay may be the pulse period of the first pulse signal, and the second delay may be the pulse period of the second pulse signal. Therefore, the delay time of the delayed output signal can be adjusted by adjusting the pulse period of the first pulse signal and the pulse period of the second pulse signal. At the same time, the operation of adjusting the delay time of the delayed output signal does not need to connect more delay units, thereby simplifying the circuit structure, and making the area of the circuit layout smaller and the power consumption of the circuit lower.

It is worth mentioning that all of the units involved in the embodiments of the disclosure may be logical units. In practical applications, a logical unit can be realized by a physical unit, a part of the physical unit, or the combination of a plurality of physical units. In addition, in order to highlight the innovative part of the disclosure, the embodiments of the disclosure do not introduce units that are not closely related to solving the technical problems proposed by the disclosure, which does not indicate that there are no other units in the embodiments of the disclosure.

The embodiments of the disclosure further provides a circuit for outputting a delayed signal, which includes G the signal output circuits mentioned above, where G is an integer greater than or equal to 2. Each stage of the signal output circuits is configured to receive a delayed output signal output by a previous-stage signal output circuit, and generate a delayed output signal of a current-stage signal output circuit according to a first pulse signal, a second pulse signal and the delayed output signal output by the previous-stage signal output circuit. Each of non-first-stage signal output circuits is configured to receive the delayed output signal output by the previous-stage signal output circuit as an input signal of a respective one of the non-first-stage signal output circuits, and a first-stage signal output circuit is configured to receive an initial input signal as an input signal of the first-stage signal output circuit. A rising edge of the delayed output signal generated by each of the signal output circuits has a first delay relative to a rising edge of the received delayed output signal output by the previous-stage signal output circuit. Additionally, a falling edge of the delayed output signal generated by each of the signal output circuits has a second delay relative to a falling edge of the revived delayed output signal output by the previous-stage signal output circuit.

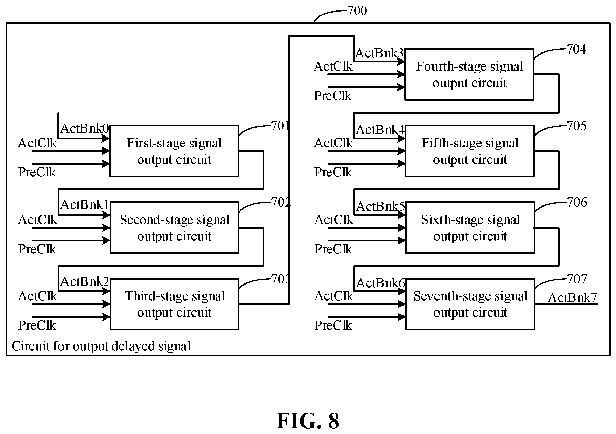

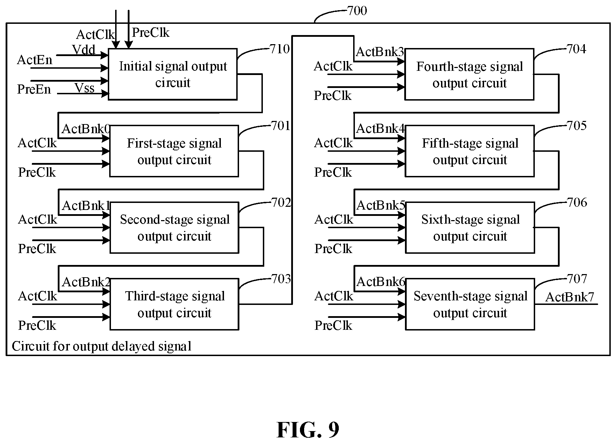

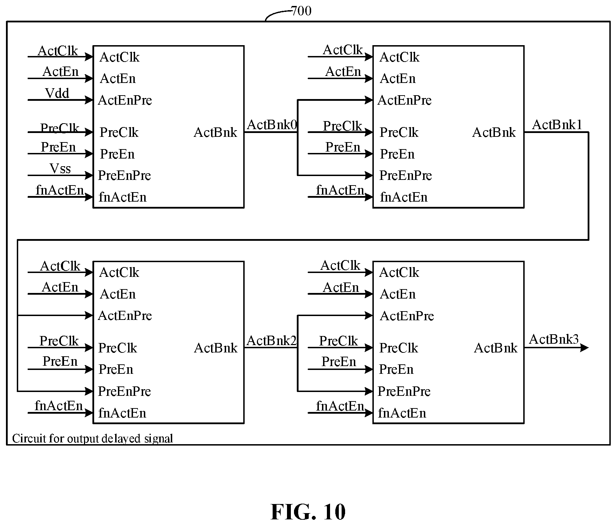

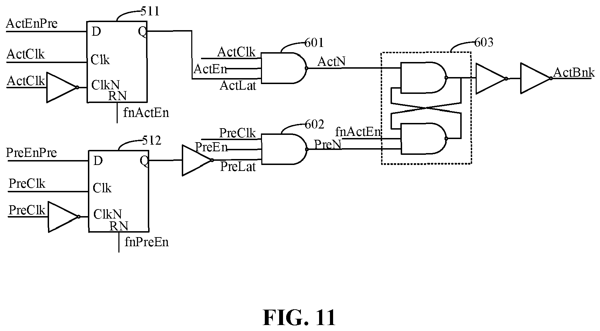

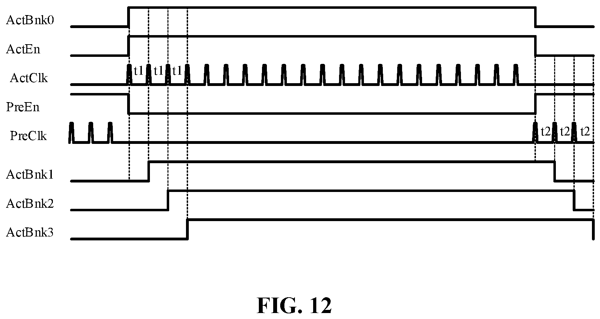

FIGS. 8 and 9 illustrate schematic structural diagrams of a circuit for outputting a delayed signal according to an embodiment of the disclosure, FIG. 10 illustrates a schematic diagram of a specific circuit of a circuit for outputting a delayed signal according to an embodiment of the disclosure, FIG. 11 illustrates a schematic diagram of a specific circuit of a signal output circuit in a circuit for outputting a delayed signal according to an embodiment of the disclosure, FIG. 12 illustrates a schematic diagram of a time sequence of signals in a circuit for outputting a delayed signal according to an embodiment of the disclosure. Hereinafter, the circuit for outputting the delayed signal according to the embodiments of the disclosure will be described in detail with reference to the accompanying drawings, the parts that are the same as or corresponding to the aforementioned embodiments will not be described in detail below.

The circuit for outputting the delayed signal includes G signal output circuits 500 according to the aforementioned embodiments, where G is an integer greater than or equal to 2. Each stage of the signal output circuits is configured to receive a delayed output signal output by a previous-stage signal output circuit, and generate a delayed output signal of a current-stage signal output circuit according to a first pulse signal ActClk, a second pulse signal PreClk and the delayed output signal output by the previous-stage signal output circuit. Each of non-first-stage signal output circuits is configured to receive the delayed output signal output by the previous-stage signal output circuit as an the input signal of a respective one of the non-first-stage signal output circuits, and a first-stage signal output circuit is configured to receive an initial input signal as an input signal of the first-stage signal output circuit. A rising edge of the delayed output signal generated by each of the signal output circuits has a first delay relative to a rising edge of the received delayed output signal output by the previous-stage signal output circuit. Additionally, a falling edge of the delayed output signal generated by each of the signal output circuits has a second delay relative to a falling edge of the revived delayed output signal output by the previous-stage signal output circuit.

In the embodiments of the disclosure, the pulse period of the first pulse signal ActClk may be t1, the pulse period of the second pulse signal PreClk may be t2, and the pulse period of the first pulse signal ActClk may be equal to the pulse period of the second pulse signal PreClk. In some embodiments of the disclosure, the pulse period of the first pulse signal and the pulse period of the second pulse signal may be different.

Referring to FIG. 8, in the embodiments of the disclosure, the circuit 700 for outputting the delayed signal may include seven signal output circuits 500 according to the aforementioned embodiments as an example for specific description, which does not constitute a limitation of the embodiments of the disclosure. Specifically, a first-stage signal output circuit 701, a second-stage signal output circuit 702, a third-stage signal output circuit 703, a fourth-stage signal output circuit 704, a fifth-stage signal output circuit 705, a sixth-stage signal output circuit 706, and a seventh-stage signal output circuit 707. In some embodiments of the disclosure, the circuit for outputting the delayed signal may include two or more signal output circuits.

In the embodiments of the disclosure, the first-stage signal output circuit 701 may be configured to generate the first-stage delayed output signal ActBnk1 according to the initial input signal ActBnk0, the first pulse signal ActClk, and the second pulse signal PreClk. The rising edge may have a first delay relative to the rising edge of the initial input signal ActBnk0, and the first delay may be the pulse period t1 of the first pulse signal ActClk. The falling edge of the first-stage delayed output signal ActBnk1 may have a second delay relative to the falling edge of the initial input signal ActBnk0, and the second delay may be the pulse period t2 of the second pulse signal PreClk.

The second-stage signal output circuit 702 may be configured to generate a second-stage delayed output signal ActBnk2 according to the first-stage delayed output signal ActBnk1, the first pulse signal ActClk, and the second pulse signal PreClk. The rising edge of the second-stage delayed output signal ActBnk2 may have a first delay relative to the first-stage delayed output signal ActBnk1; and the falling edge of the second-stage delayed output signal ActBnk2 may have a second delay relative to the first-stage delayed output signal ActBnk1.

The third-stage signal output circuit 703 may be configured to generate a third-stage delayed output signal ActBnk3 according to the second-stage delayed output signal ActBnk2, the first pulse signal ActClk, and the second pulse signal PreClk. The rising edge of the third-stage delayed output signal ActBnk3 may have a first delay relative to the second-stage delayed output signal ActBnk2; and the falling edge of the third-stage delayed output signal ActBnk3 may have a second delay relative to the second-stage delayed output signal ActBnk2.

The fourth-stage signal output circuit 704 may be configured to generate a fourth-stage delayed output signal ActBnk4 according to the third-stage delayed output signal ActBnk3, the first pulse signal ActClk, and the second pulse signal PreClk. The rising edge of the fourth-stage delayed output signal ActBnk4 may have a first delay relative to the third-stage delayed output signal ActBnk3; and the falling edge of the fourth-stage delayed output signal ActBnk4 may have a second delay relative to the third-stage delayed output signal ActBnk3.

The fifth-stage signal output circuit 705 may be configured to generate a fifth-stage delayed output signal ActBnk5 according to the fourth-stage delayed output signal ActBnk4, the first pulse signal ActClk, and the second pulse signal PreClk. The rising edge of the fifth-stage delayed output signal ActBnk5 may have a first delay relative to the fourth-stage delayed output signal ActBnk4; and the falling edge of the fifth-stage delayed output signal ActBnk5 may have a second delay relative to the fourth-stage delayed output signal ActBnk4.

The sixth-stage signal output circuit 706 may be configured to generate a sixth-stage delayed output signal ActBnk6 according to the fifth-stage delayed output signal ActBnk5, the first pulse signal ActClk, and the second pulse signal PreClk. The rising edge of the sixth-stage delayed output signal ActBnk6 may have a first delay relative to the fifth-stage delayed output signal ActBnk5; and the falling edge of the sixth-stage delayed output signal ActBnk6 may have a second delay relative to the fifth-stage delayed output signal ActBnk5.

The seventh-stage signal output circuit 707 may be configured to generate a seventh-stage delayed output signal ActBnk7 according to the sixth-stage delayed output signal ActBnk6, the first pulse signal ActClk, and the second pulse signal PreClk. The rising edge of the seventh-stage delayed output signal ActBnk7 may have a first delay relative to the sixth-stage delayed output signal ActBnk6; and the falling edge of the seventh-stage delayed output signal ActBnk7 may have a second delay relative to the sixth-stage delayed output signal ActBnk6.

Referring to FIG. 9, in the embodiments of the disclosure, the first control module of the signal output circuits may further be configured to receive a first control signal ActEn. And the second control module of the signal output circuits may further be configured to receive a second control signal PreEn. The first pulse signalActClk and the second pulse signal PreClk may be inverted signals. The each stage of the signal output circuits may be configured to generate the delayed output signal of the current-stage signal output circuit according to the first control signal ActEn, the second control signal PreEn, the first pulse signal ActClk, the second pulse signal PreClk and the delayed output signal output by the previous-stage signal output circuit. By receiving the first control signal ActEn and the second control signal PreEn, the stability of the output by the signal output circuit can be ensured.

Continuing to refer to FIG. 9, in the embodiments of the disclosure, the circuit 700 for outputting the delayed signal may further include: an initial signal output circuit 710 that includes a first control module, a second control module, and a signal output module. The first control module of the initial signal output circuit may be configured to receive the first pulse signal ActClk and a first power signal Vdd, and generate the first adjustment signal (not illustrated) according to the first pulse signal ActClk and the first power signal Vdd. The second control module of the initial signal output circuit may be configured to receive a second pulse signal PreClk and a second power signal Vss, and generate the second adjustment signal (not illustrated) according to the second pulse signal PreClk and the second power signal Vss. The signal output module of the initial signal output circuit may be configured to generate the initial input signal according to the first adjustment signal (not illustrated) and the second adjustment signal (not illustrated). The delayed output signal of the initial signal output circuit may be generated according to the first power signal Vdd and the second power signal Vss; that is, the initial input signal ActBnk0 output by the initial signal output circuit 710 can avoid the delay caused by the circuit elements of the signal output circuit, compared with the initial input signal ActBnk0 directly input from the external. The initial signal output circuit 710 here may be the same as the signal output circuit described above, which will not be repeated here, but the embodiments of the disclosure is not limited thereto.

In some embodiments of the disclosure, referring to FIGS. 10 and 11, the figures are introduced by taking a circuit 700 for outputting a delayed signal composed of four signal output circuits as an example. The first clock terminal ActClk of the signal output circuits may be configured to receive the first pulse signal ActClk. The second clock terminal PreClk of the signal output circuits may be configured to receive the second pulse signal PreClk. The first control terminal ActEn of the signal output circuits may be configured to receive the first control signal ActEn. The second control terminal PreEn of the signal output circuits may be configured to receive the second control signal PreEn. The signal output terminal ActBnk of the signal output circuits may be configured to output the delayed output signal of the current-stage signal output circuit. The signal output circuit may further include a first signal terminal ActEnPre and a second signal terminal PreEnPre (i.e., the signal input terminals of the signal output circuit). With reference to FIG. 11, the first signal terminal ActEnPre of the initial signal output circuit may be configured to receive the first power signal Vdd, and the second signal terminal PreEnPre of the initial signal output circuit may be configured to receive the second power signal Vss. The first signal terminal ActEnPre and the second signal terminal PreEnPre of other signal output circuits may be configured to receive the delayed output signal output by the previous-stage signal output circuit.

Referring to FIGS. 9 and 12, according to the aforementioned description, it can be known that the first-stage signal output circuit 701 may be configured to generate a first-stage delayed output signal ActBnk1 according to the initial input signal ActBnk0, and the second-stage signal output circuit 702 may be configured to generate a second-stage delayed output signal ActBnk2 according to the first-stage delayed output signal ActBnk1. The third-stage signal output circuit 703 may be configured to generate the third-stage delayed output signal ActBnk3 according to the second-stage delayed output signal ActBnk2, and the fourth-stage signal output circuit 704 may be configured to generate the fourth-stage delayed output signal ActBnk4 (not illustrated) according to the third-stage delayed output signal ActBnk3. The fifth-stage signal output circuit 705 may be configured to generate a fifth-stage delayed output signal ActBnk5 (not illustrated) according to the fourth-stage delayed output signal ActBnk4, the sixth-stage signal output circuit 706 may be configured to generate a sixth-stage delayed output signal ActBnk6 (not illustrated) according to the fifth-stage delayed output signal ActBnk5, and the seventh-stage signal output circuit 707 may be configured to generate a seventh-stage delayed output signal ActBnk7 (not illustrated) according to the sixth-stage delayed output signal ActBnk6.

It should be understood that the signal output circuit can be configured to generate a delayed signal with a controllable delay according to the first pulse signal and the second pulse signal. Compared with the input signal, the delayed signal may have a first delay on the rising edge and a second delay on the falling edge. Other signal output circuits may continue to delay the generated delayed signal, thereby generating stagger signals that are equally spaced. And at the same time, the operation of adjusting the delay time of the delayed signal does not need to connect more delay units, thereby simplifying the circuit structure, and making the area of the circuit layout smaller and the power consumption of the circuit lower.

It is worth mentioning that all of the units involved in the embodiments of the disclosure may be logical units. In practical applications, a logical unit can be realized by a physical unit, a part of the physical unit, or the combination of a plurality of physical units. In addition, in order to highlight the innovative part of the disclosure, the embodiments of the disclosure do not introduce units that are not closely related to solving the technical problems proposed by the disclosure, which does not indicate that there are no other units in the embodiments of the disclosure.

Since the aforementioned embodiments correspond to the embodiments of the disclosure, the embodiments of the disclosure can be implemented in cooperation with the aforementioned embodiments. The related technical details mentioned in the aforementioned embodiments are still valid in the embodiments of the disclosure, and the technical effects that can be achieved in the aforementioned embodiments can also be achieved in the embodiments of the disclosure. In order to reduce repetition, details will not be repeated here. Correspondingly, the related technical details mentioned in the embodiments of the disclosure can also be applied to the aforementioned embodiments.

Those of ordinary skill in the art can understand that the aforementioned embodiments are specific embodiments for realizing the disclosure; and in practical applications, various changes can be made to them in form and details without departing from the scope of the claims.

### INDUSTRIAL APPLICABILITY

Embodiments of the disclosure provide a circuit for outputting a delayed signal, comprising G signal output circuits, where G is an integer greater than or equal to 2; wherein each stage of the signal output circuits is configured to receive a delayed output signal output by a previous-stage signal output circuit and generate a delayed output signal of a current-stage signal output circuit according to a first pulse signal, a second pulse signal and the delayed output signal output by the previous-stage signal output circuit; wherein each of non-first-stage signal output circuits is configured to receive the delayed output signal output by the previous-stage signal output circuit as an input signal of a respective one of the non-first-stage signal output circuits; and a first-stage signal output circuit is configured to receive an initial input signal as an input signal of the first-stage signal output circuit; wherein a rising edge of the delayed output signal generated by each of the signal output circuits has a first delay relative to a rising edge of the received delayed output signal output by the previous-stage signal output circuit; and wherein a falling edge of the delayed output signal generated by each of the signal output circuits has a second delay relative to a falling edge of the revived delayed output signal output by the previous-stage signal output circuit; wherein the signal output circuit, comprising:a first control module, configured to receive a first pulse signal and an input signal, and output a first adjustment signal, wherein a first preset edge of the first adjustment signal has a first delay relative to a rising edge of the input signal, the first delay being a pulse period of the first pulse signal; a second control module, configured to receive a second pulse signal and the input signal, and output a second adjustment signal, wherein a second preset edge of the second adjustment signal has a second delay relative to a falling edge of the input signal, the second delay being a pulse period of the second pulse signal; and a signal output module, configured to receive the first adjustment signal and the second adjustment signal, and output a delayed output signal, a rising edge of the delayed output signal is generated according to the first preset edge of the first adjustment signal, and a falling edge of the delayed output signal is generated according to the second preset edge of the second adjustment signal; wherein the signal output module comprises: a first receiving unit, configured to receive the first pulse signal and the first adjustment signal, and generate a first pulse control signal when the first adjustment signal is at an active level, wherein a pulse phase of first pulse control signal is opposite to a pulse phase of the first pulse signal; a second receiving unit, configured to receive the second pulse signal and the second adjustment signal, and generate a second pulse control signal when the second adjustment signal is at an active level, wherein a pulse phase of the second pulse control signal is opposite to a pulse phase of the second pulse signal; and a latch unit, configured to receive the first pulse control signal and the second pulse control signal, and generate the delayed output signal.

In the embodiments of the disclosure, a delayed output signal with a controllable delay can be generated according to the first pulse signal and the second pulse signal. Compared with the input signal, the delayed output signal has a first delay on the rising edge and has a second delay on the falling edge; the first delay is the pulse period of the first pulse signal, and the second delay is the pulse period of the second pulse signal. Therefore, the delay time of the delayed output signal can be adjusted by adjusting the pulse periods of the first pulse signal and the second pulse signal. At the same time, the operation of adjusting the delay time of the delayed output signal does not need to connect more delay units, thereby simplifying the circuit structure, making the area of the circuit layout smaller and the power consumption of the circuit lower.

## Claims

1. A circuit (700) for outputting a delayed signal, comprising G signal output circuits (500), where G is an integer greater than or equal to 2;
wherein each stage of the signal output circuits (500) is configured to receive a delayed output signal output by a previous-stage signal output circuit and generate a delayed output signal of a current-stage signal output circuit according to a first pulse signal, a second pulse signal and the delayed output signal output by the previous-stage signal output circuit;
wherein each of non-first-stage signal output circuits is configured to receive the delayed output signal output by the previous-stage signal output circuit as an input signal of a respective one of the non-first-stage signal output circuits; and a first-stage signal output circuit (701) is configured to receive an initial input signal as an input signal of the first-stage signal output circuit (701);
wherein a rising edge of the delayed output signal generated by each of the signal output circuits (500) has a first delay relative to a rising edge of the received delayed output signal output by the previous-stage signal output circuit; and
wherein a falling edge of the delayed output signal generated by each of the signal output circuits (500) has a second delay relative to a falling edge of the revived delayed output signal output by the previous-stage signal output circuit;
wherein the signal output circuit (500), comprising:
a first control module (501), configured to receive a first pulse signal and an input signal, and output a first adjustment signal, wherein a first preset edge of the first adjustment signal has a first delay relative to a rising edge of the input signal, the first delay being a pulse period of the first pulse signal;
a second control module (502), configured to receive a second pulse signal and the input signal, and output a second adjustment signal, wherein a second preset edge of the second adjustment signal has a second delay relative to a falling edge of the input signal, the second delay being a pulse period of the second pulse signal; and
a signal output module (503), configured to receive the first adjustment signal and the second adjustment signal, and output a delayed output signal, a rising edge of the delayed output signal is generated according to the first preset edge of the first adjustment signal, and a falling edge of the delayed output signal is generated according to the second preset edge of the second adjustment signal;
wherein the signal output module (503) comprises:
a first receiving unit (513), configured to receive the first pulse signal and the first adjustment signal, and generate a first pulse control signal when the first adjustment signal is at an active level, wherein a pulse phase of first pulse control signal is opposite to a pulse phase of the first pulse signal;
a second receiving unit (523), configured to receive the second pulse signal and the second adjustment signal, and generate a second pulse control signal when the second adjustment signal is at an active level, wherein a pulse phase of the second pulse control signal is opposite to a pulse phase of the second pulse signal; and
a latch unit (533), configured to receive the first pulse control signal and the second pulse control signal, and generate the delayed output signal.

2. The circuit (700) for outputting the delayed signal of claim 1, wherein the pulse period of the first pulse signal is equal to the pulse period of the second pulse signal.

3. The circuit (700) for outputting the delayed signal of claim 1, wherein one pulse of the first pulse signal is aligned with the rising edge of the input signal, and one pulse of the second pulse signal is aligned with the falling edge of the input signal.

4. The circuit (700) for outputting the delayed signal of claim 3, wherein the first pulse signal and the second pulse signal are staggered with each other.

5. The circuit (700) for outputting the delayed signal of claim 1, wherein the first receiving unit (513) is further configured to receive a first control signal, and generate the first pulse control signal according to the first pulse signal when the first adjustment signal and the first control signal are both at active levels; or
wherein the second receiving unit (523) is further configured to receive a second control signal, and generate the second pulse control signal according to the second pulse signal when the second adjustment signal and the second control signal are both at active levels.

6. The circuit (700) for outputting the delayed signal of claim 1, wherein the first receiving unit (513) comprises a first receiving NAND gate (601); and the first receiving NAND gate (601) comprises a first input terminal, a second input terminal and a first output terminal, the first input terminal being configured to receive the first adjustment signal, the second input terminal being configured to receive the first pulse signal, and the first output terminal being configured to output the first pulse control signal; or
wherein the second receiving unit (523) comprises a second receiving NAND gate (602); and the second receiving NAND gate (602) comprises a third input terminal, a fourth input terminal and a second output terminal, the third input terminal being configured to receive the second adjustment signal, the fourth input terminal being configured to receive the second pulse signal, and the second output terminal being configured to output the second pulse control signal.

7. The circuit (700) for outputting the delayed signal of claim 1, wherein the latch unit (533) comprises a latch (603), and the latch (603) comprises a fifth input terminal, a sixth input terminal and a third output terminal, the fifth input terminal being configured to receive the first pulse control signal, the sixth input terminal being configured to receive the second pulse control signal, and the third output terminal being configured to output the delay output signal.

8. The circuit (700) for outputting the delayed signal of claim 7, wherein the latch unit (533) is configured such that:
the delayed output signal and the second pulse control signal are both at a same level, when the first pulse control signal and the second pulse control signal are at different levels; and
the latch unit (533) maintains a state, when the first pulse control signal and the second pulse control signal are both at high levels.

9. The circuit (700) for outputting the delayed signal of claim 1, wherein the first control module (501) comprises: a first D-trigger (511), wherein a clock terminal of the first D-trigger (511) is configured to receive the first pulse signal, a reset terminal of the first D-trigger (511) is configured to receive a first reset signal, an input terminal of the first D-trigger (511) is configured to receive the input signal, and an output terminal of the first D-trigger (511) is configured to output the first adjustment signal; or
wherein the second control module (502) comprises: a second D-trigger (512), wherein a clock terminal of the second D-trigger (512) is configured to receive the second pulse signal, a reset terminal of the second D-trigger (512) is configured to receive a second reset signal, an input terminal of the second D-trigger (512) is configured to receive the input signal, and an output terminal of the second D-trigger (512) is serially connected with an inverter and configured to output the second adjustment signal at an output of the inverter.

10. The circuit (700) for outputting the delayed signal of claim 1, the signal output circuit (500) further comprising: an even number of inverters, wherein the inverters are serially connected with an output terminal of the signal output module (503).

11. The circuit (700) for outputting the delayed signal of claim 1, wherein a pulse period of the first pulse signal is equal to a pulse period of the second pulse signal.

12. The circuit (700) for outputting the delayed signal of claim 1, the first control module (501) of the signal output circuits (500) is further configured to receive a first control signal, and the second control module (502) of the signal output circuits (500) is further configured to receive a second control signal, and the first control signal and the second control signal are inverted signals;
the each stage of the signal output circuits (500) is configured to generate the delayed output signal of the current-stage signal output circuit according to the first control signal, the second control signal, the first pulse signal, the second pulse signal and the delayed output signal output by the previous-stage signal output circuit.

13. The circuit (700) for outputting the delayed signal of claim 1, further comprising:
an initial signal output circuit (710) comprising a first control module (501), a second control module (502), and a signal output module (503);
wherein the first control module (501) of the initial signal output circuit (710) is configured to receive the first pulse signal and a first power signal, and generate the first adjustment signal according to the first pulse signal and the first power signal;
the second control module (502) of the initial signal output circuit (710) is configured to receive the second pulse signal and a second power signal, and generate the second adjustment signal according to the second pulse signal and the second power signal;
the signal output module (503) of the initial signal output circuit (710) is configured to generate the initial input signal according to the first adjustment signal and the second adjustment signal.

## Patentansprüche

1. Schaltung (700) zum Ausgeben eines verzögerten Signals, die G Signalausgabeschaltungen (500) umfasst, wobei G eine ganze Zahl größer oder gleich 2 ist;
wobei jede Stufe der Signalausgabeschaltungen (500) konfiguriert ist, um ein verzögertes Ausgabesignal zu empfangen, das von einer Signalausgabeschaltung der vorherigen Stufe ausgegeben wird, und ein verzögertes Ausgabesignal einer Signalausgabeschaltung der aktuellen Stufe gemäß einem ersten Impulssignal, einem zweiten Impulssignal und dem verzögerten Ausgabesignal, das von der Signalausgabeschaltung der vorherigen Stufe ausgegeben wird, zu erzeugen;
wobei jede von Signalausgabeschaltungen einer nicht ersten Stufe konfiguriert ist, um das verzögerte Ausgabesignal, das von der Signalausgabeschaltung der vorherigen Stufe ausgegeben wird, als ein Eingabesignal einer jeweiligen der Signalausgabeschaltungen der nicht ersten Stufe zu empfangen; und eine Signalausgabeschaltung (701) der ersten Stufe konfiguriert ist, um ein anfängliches Eingabesignal als ein Eingabesignal der Signalausgabeschaltung (701) der ersten Stufe zu empfangen;
wobei eine ansteigende Flanke des verzögerten Ausgabesignals, das von jeder der Signalausgabeschaltungen (500) erzeugt wird, eine erste Verzögerung relativ zu einer ansteigenden Flanke des empfangenen verzögerten Ausgabesignals aufweist, das von der Signalausgabeschaltung der vorherigen Stufe ausgegeben wird; und
wobei eine abfallende Flanke des verzögerten Ausgabesignals, das von jeder der Signalausgabeschaltungen (500) erzeugt wird, eine zweite Verzögerung relativ zu einer abfallenden Flanke des wiederbelebten verzögerten Ausgabesignals aufweist, das von der Signalausgabeschaltung der vorherigen Stufe ausgegeben wird;
wobei die Signalausgabeschaltung (500) Folgendes umfasst:
ein erstes Steuermodul (501), das konfiguriert ist, um ein erstes Impulssignal und ein Eingabesignal zu empfangen und ein erstes Anpassungssignal auszugeben, wobei eine erste voreingestellte Flanke des ersten Anpassungssignals eine erste Verzögerung relativ zu einer ansteigenden Flanke des Eingabesignals aufweist, wobei die erste Verzögerung eine Impulsperiode des ersten Impulssignals ist;
ein zweites Steuermodul (502), das konfiguriert ist, um ein zweites Impulssignal und das Eingabesignal zu empfangen und ein zweites Anpassungssignal auszugeben, wobei eine zweite voreingestellte Flanke des zweiten Anpassungssignals eine zweite Verzögerung relativ zu einer abfallenden Flanke des Eingabesignals aufweist, wobei die zweite Verzögerung eine Impulsperiode des zweiten Impulssignals ist; und
ein Signalausgabemodul (503), das konfiguriert ist, um das erste Anpassungssignal und das zweite Anpassungssignal zu empfangen und ein verzögertes Ausgabesignal auszugeben, wobei eine ansteigende Flanke des verzögerten Ausgabesignals gemäß der ersten voreingestellten Flanke des ersten Anpassungssignals erzeugt wird und eine abfallende Flanke des verzögerten Ausgabesignals gemäß der zweiten voreingestellten Flanke des zweiten Anpassungssignals erzeugt wird;
wobei das Signalausgabemodul (503) Folgendes umfasst:
eine erste Empfangseinheit (513), die so konfiguriert ist, dass sie das erste Impulssignal und das erste Anpassungssignal empfängt und ein erstes Impulssteuersignal erzeugt, wenn sich das erste Anpassungssignal auf einem aktiven Pegel befindet, wobei eine Impulsphase des ersten Impulssteuersignals zu einer Impulsphase des ersten Impulssignals entgegengesetzt ist;
eine zweite Empfangseinheit (523), die so konfiguriert ist, dass sie das zweite Impulssignal und das zweite Anpassungssignal empfängt und ein zweites Impulssteuersignal erzeugt, wenn sich das zweite Anpassungssignal auf einem aktiven Pegel befindet, wobei eine Impulsphase des zweiten Impulssteuersignals zu einer Impulsphase des zweiten Impulssignals entgegengesetzt ist; und
eine Latch-Einheit (533), die konfiguriert ist, um das erste Impulssteuersignal und das zweite Impulssteuersignal zu empfangen und das verzögerte Ausgabesignal zu erzeugen.

2. Schaltung (700) zum Ausgeben des verzögerten Signals nach Anspruch 1, wobei die Impulsperiode des ersten Impulssignals gleich der Impulsperiode des zweiten Impulssignals ist.

3. Schaltung (700) zum Ausgeben des verzögerten Signals nach Anspruch 1, wobei ein Impuls des ersten Impulssignals an der ansteigenden Flanke des Eingabesignals ausgerichtet ist und ein Impuls des zweiten Impulssignals an der abfallenden Flanke des Eingabesignals ausgerichtet ist.

4. Schaltung (700) zum Ausgeben des verzögerten Signals nach Anspruch 3, wobei das erste Impulssignal und das zweite Impulssignal zueinander versetzt sind.

5. Schaltung (700) zum Ausgeben des verzögerten Signals nach Anspruch 1, wobei die erste Empfangseinheit (513) ferner so konfiguriert ist, dass sie ein erstes Steuersignal empfängt und das erste Impulssteuersignal gemäß dem ersten Impulssignal erzeugt, wenn sich das erste Anpassungssignal und das erste Steuersignal beide auf aktiven Pegeln befinden; oder
wobei die zweite Empfangseinheit (523) ferner so konfiguriert ist, dass sie ein zweites Steuersignal empfängt und das zweite Impulssteuersignal gemäß dem zweiten Impulssignal erzeugt, wenn sich das zweite Anpassungssignal und das zweite Steuersignal beide auf aktiven Pegeln befinden.

6. Schaltung (700) zum Ausgeben des verzögerten Signals nach Anspruch 1, wobei die erste Empfangseinheit (513) ein erstes Empfangs-NAND-Gate (601) umfasst; und das erste Empfangs-NAND-Gate (601) einen ersten Eingabeanschluss, einen zweiten Eingabeanschluss und einen ersten Ausgabeanschluss umfasst, wobei der erste Eingabeanschluss konfiguriert ist, um das erste Anpassungssignal zu empfangen, der zweite Eingabeanschluss konfiguriert ist, um das erste Impulssignal zu empfangen, und der erste Ausgabeanschluss konfiguriert ist, um das erste Impulssteuersignal auszugeben; oder
wobei die zweite Empfangseinheit (523) ein zweites Empfangs-NAND-Gate (602) umfasst; und das zweite Empfangs-NAND-Gate (602) einen dritten Eingabeanschluss, einen vierten Eingabeanschluss und einen zweiten Ausgabeanschluss umfasst, wobei der dritte Eingabeanschluss konfiguriert ist, um das zweite Anpassungssignal zu empfangen, der vierte Eingabeanschluss konfiguriert ist, um das zweite Impulssignal zu empfangen, und der zweite Ausgabeanschluss konfiguriert ist, um das zweite Impulssteuersignal auszugeben.

7. Schaltung (700) zum Ausgeben des verzögerten Signals nach Anspruch 1, wobei die Latch-Einheit (533) einen Latch (603) umfasst und der Latch (603) einen fünften Eingabeanschluss, einen sechsten Eingabeanschluss und einen dritten Ausgabeanschluss umfasst, wobei der fünfte Eingabeanschluss konfiguriert ist, um das erste Impulssteuersignal zu empfangen, der sechste Eingabeanschluss konfiguriert ist, um das zweite Impulssteuersignal zu empfangen, und der dritte Ausgabeanschluss konfiguriert ist, um das verzögerte Ausgabesignal auszugeben.

8. Schaltung (700) zum Ausgeben des verzögerten Signals nach Anspruch 7, wobei die Latch-Einheit (533) so konfiguriert ist, dass:
sich das verzögerte Ausgabesignal und das zweite Impulssteuersignal beide auf einem gleichen Pegel befinden, wenn sich das erste Impulssteuersignal und das zweite Impulssteuersignal auf unterschiedlichen Pegeln befinden; und
die Latch-Einheit (533) einen Zustand beibehält, wenn sich das erste Impulssteuersignal und das zweite Impulssteuersignal beide auf hohen Pegeln befinden.

9. Schaltung (700) zum Ausgeben des verzögerten Signals nach Anspruch 1, wobei das erste Steuermodul (501) Folgendes umfasst: einen ersten D-Trigger (511), wobei ein Taktanschluss des ersten D-Triggers (511) so konfiguriert ist, dass er das erste Impulssignal empfängt, ein Rücksetzanschluss des ersten D-Triggers (511) so konfiguriert ist, dass er ein erstes Rücksetzsignal empfängt, ein Eingabeanschluss des ersten D-Triggers (511) so konfiguriert ist, dass er das Eingabesignal empfängt, und ein Ausgabeanschluss des ersten D-Triggers (511) so konfiguriert ist, dass er das erste Anpassungssignal ausgibt; oder
wobei das zweite Steuermodul (502) Folgendes umfasst: einen zweiten D-Trigger (512), wobei ein Taktanschluss des zweiten D-Triggers (512) so konfiguriert ist, dass er das zweite Impulssignal empfängt, ein Rücksetzanschluss des zweiten D-Triggers (512) so konfiguriert ist, dass er ein zweites Rücksetzsignal empfängt, ein Eingabeanschluss des zweiten D-Triggers (512) so konfiguriert ist, dass er das Eingabesignal empfängt, und ein Ausgabeanschluss des zweiten D-Triggers (512) in Reihe mit einem Wechselrichter verbunden ist und so konfiguriert ist, dass er das zweite Anpassungssignal an einen Ausgang des Wechselrichters ausgibt.

10. Schaltung (700) zum Ausgeben des verzögerten Signals nach Anspruch 1, wobei die Signalausgabeschaltung (500) ferner Folgendes umfasst: eine gerade Anzahl von Wechselrichtern, wobei die Wechselrichter in Reihe mit einem Ausgabeanschluss des Signalausgabemoduls (503) verbunden sind.

11. Schaltung (700) zum Ausgeben des verzögerten Signals nach Anspruch 1, wobei eine Impulsperiode des ersten Impulssignals gleich einer Impulsperiode des zweiten Impulssignals ist.

12. Schaltung (700) zum Ausgeben des verzögerten Signals nach Anspruch 1, wobei das erste Steuermodul (501) der Signalausgabeschaltungen (500) ferner so konfiguriert ist, dass es ein erstes Steuersignal empfängt, und das zweite Steuermodul (502) der Signalausgabeschaltungen (500) ferner so konfiguriert ist, dass es ein zweites Steuersignal empfängt, und das erste Steuersignal und das zweite Steuersignal invertierte Signale sind;
wobei jede Stufe der Signalausgabeschaltungen (500) konfiguriert ist, um das verzögerte Ausgabesignal der Signalausgabeschaltung der aktuellen Stufe gemäß dem ersten Steuersignal, dem zweiten Steuersignal, dem ersten Impulssignal, dem zweiten Impulssignal und dem verzögerten Ausgabesignal, das von der Signalausgabeschaltung der vorherigen Stufe ausgegeben wird, zu erzeugen.

13. Schaltung (700) zum Ausgeben des verzögerten Signals nach Anspruch 1, ferner umfassend:
eine anfängliche Signalausgabeschaltung (710), die ein erstes Steuermodul (501), ein zweites Steuermodul (502) und ein Signalausgabemodul (503) umfasst;
wobei das erste Steuermodul (501) der anfänglichen Signalausgabeschaltung (710) konfiguriert ist, um das erste Impulssignal und ein erstes Leistungssignal zu empfangen und das erste Anpassungssignal gemäß dem ersten Impulssignal und dem ersten Leistungssignal zu erzeugen;
das zweite Steuermodul (502) der anfänglichen Signalausgabeschaltung (710) konfiguriert ist, um das zweite Impulssignal und ein zweites Leistungssignal zu empfangen und das zweite Anpassungssignal gemäß dem zweiten Impulssignal und dem zweiten Leistungssignal zu erzeugen;
das Signalausgabemodul (503) der anfänglichen Signalausgabeschaltung (710) konfiguriert ist, um das anfängliche Eingabesignal gemäß dem ersten Anpassungssignal und dem zweiten Anpassungssignal zu erzeugen.

## Revendications

1. Circuit (700) de sortie d'un signal retardé comprenant des circuits de sortie de signal G (500), où G est un nombre entier supérieur ou égal à 2 ;
dans lequel chaque étage des circuits de sortie de signal (500) est configuré pour recevoir un signal de sortie retardé émis par un circuit de sortie de signal d'étage précédent et pour générer un signal de sortie retardé d'un circuit de sortie de signal d'étage actuel en fonction d'un premier signal d'impulsion, d'un deuxième signal d'impulsion et du signal de sortie retardé émis par le circuit de sortie de signal d'étage précédent ;
dans lequel chacun de circuits de sortie de signal d'étage autre que le premier est configuré pour recevoir le signal de sortie retardé émis par le circuit de sortie de signal d'étage autre que le premier en tant que signal d'entrée d'un circuit respectif des circuits de sortie de signal d'étage autre que le premier ; et un circuit de sortie de signal d'étage autre que le premier (701) est configuré pour recevoir un signal d'entrée initial en tant que signal d'entrée du circuit de sortie de signal d'étage autre que le premier (701) ;
dans lequel un front montant du signal de sortie retardé généré par chacun des circuits de sortie de signal (500) présente un premier retard par rapport à un front montant du signal de sortie retardé reçu émis par le circuit de sortie de signal d'étage précédent ; et
dans lequel un front descendant du signal de sortie retardé généré par chacun des circuits de sortie de signal (500) présente un deuxième retard par rapport à un front descendant du signal de sortie retardé ravivé produit par le circuit de sortie de signal d'étage précédent ;
dans lequel le circuit de sorte de signal (500) comprend :
un premier module de commande (501) configuré pour recevoir un premier signal d'impulsion et un signal d'entrée, et émettre un premier signal d'ajustement, dans lequel un premier front prédéfini du premier signal d'ajustement présente un premier retard par rapport à un front montant du signal d'entrée, le premier retard étant une période d'impulsion du premier signal d'impulsion ;
un deuxième module de commande (502), configuré pour recevoir un deuxième signal d'impulsion et le signal d'entrée, et émettre un deuxième signal d'ajustement, dans lequel un deuxième front prédéfini du deuxième signal d'ajustement présente un deuxième retard par rapport à un front descendant du signal d'entrée, le deuxième retard étant une période d'impulsion du deuxième signal d'impulsion ; et
un module de sortie de signal (503), configuré pour recevoir le premier signal d'ajustement et le deuxième signal d'ajustement, et émettre un signal de sortie retardé, un front montant du signal de sortie retardé étant généré en fonction du premier front prédéfini du premier signal d'ajustement, et un front descendant du signal de sortie retardé étant généré en fonction du deuxième front prédéfini du deuxième signal d'ajustement ;
dans lequel le module de sortie de signal (503) comprend :
une première unité de réception (513) configurée pour recevoir le premier signal d'impulsion et le premier signal d'ajustement, et pour générer un premier signal de commande d'impulsion lorsque le premier signal d'ajustement est à un niveau actif, dans lequel une phase d'impulsion du premier signal de commande d'impulsion est opposée à une phase d'impulsion du premier signal d'impulsion ;
une deuxième unité de réception (523) configurée pour recevoir le deuxième signal d'impulsion et le deuxième signal d'ajustement, et pour générer un deuxième signal d'impulsion lorsque le deuxième signal d'ajustement est à un niveau actif, dans lequel une phase d'impulsion du deuxième signal de commande d'impulsion est opposée à une phase d'impulsion du deuxième signal d'impulsion ; et
une unité de verrouillage (533), configurée pour recevoir le premier signal de commande d'impulsion et le deuxième signal de commande d'impulsion, et pour générer le signal de sortie retardé.

2. Circuit (700) de sortie du signal retardé de la revendication 1, dans lequel la période d'impulsion du premier signal d'impulsion est égale à la période d'impulsion du deuxième signal d'impulsion.

3. Circuit (700) de sortie du signal retardé de la revendication 1, dans lequel une impulsion du premier signal d'impulsion est alignée sur le front montant du signal d'entrée, et une impulsion du deuxième signal d'impulsion est alignée sur le front descendant du signal d'entrée.

4. Circuit (700) de sortie du signal retardé de la revendication 3, dans lequel le premier signal d'impulsion et le deuxième signal d'impulsion sont décalés l'un par rapport à l'autre.

5. Circuit (700) de sortie du signal retardé de la revendication 1, dans lequel la première unité de réception (513) est en outre configurée pour recevoir un premier signal de commande, et générer le premier signal de commande d'impulsion en fonction du premier signal d'impulsion lorsque le premier signal d'ajustement et le premier signal de commande sont tous deux à des niveaux actifs ; ou
dans lequel la deuxième unité de réception (523) est en outre configurée pour recevoir un deuxième signal de commande, et générer le deuxième signal de commande d'impulsion en fonction du deuxième signal d'impulsion lorsque le deuxième signal d'ajustement et le deuxième signal de commande sont tous deux à des niveaux actifs.

6. Circuit (700) de sortie du signal retardé de la revendication 1, dans lequel la première unité de réception (513) comprend une première porte NAND de réception (601) ; et la première porte NAND de réception (601) comprend une première borne d'entrée, une deuxième borne d'entrée et une première borne de sortie, la première borne d'entrée étant configurée pour recevoir le premier signal d'ajustement, la deuxième borne d'entrée étant configurée pour recevoir le premier signal d'impulsion, et la première borne de sortie étant configurée pour émettre le premier signal de commande d'impulsion ; ou
dans lequel la deuxième unité de réception (523) comprend une deuxième porte NAND de réception (602) ; et la deuxième porte NAND de réception (602) comprend une troisième borne d'entrée, une quatrième borne d'entrée et une deuxième borne de sortie, la troisième borne d'entrée étant configurée pour recevoir le deuxième signal d'ajustement, la quatrième borne d'entrée étant configurée pour recevoir le deuxième signal d'impulsion, et la deuxième borne de sortie étant configurée pour émettre le deuxième signal de commande d'impulsion.

7. Circuit (700) de sortie du signal retardé de la revendication 1, dans lequel l'unité de verrouillage (533) comprend un verrou (603), et le verrou (603) comprend une cinquième borne d'entrée, une sixième borne d'entrée et une troisième borne de sortie, la cinquième borne d'entrée étant configurée pour recevoir le premier signal de commande d'impulsion, la sixième borne d'entrée étant configurée pour recevoir le deuxième signal de commande d'impulsion, et la troisième borne de sortie étant configurée pour émettre le signal de sortie retardé.

8. Circuit (700) de sortie du signal retardé de la revendication 7, dans lequel l'unité de verrouillage (533) est configurée de telle sorte que :
le signal de sortie retardé et le deuxième signal de commande d'impulsion sont tous deux à un même niveau, lorsque le premier signal de commande d'impulsion et le deuxième signal de commande d'impulsion sont à des niveaux différents ; et
l'unité de verrouillage (533) maintient un état lorsque le premier signal de commande d'impulsion et le deuxième signal de commande d'impulsion sont tous deux à des niveaux élevés.

9. Circuit (700) de sortie du signal retardé de la revendication 1, dans lequel le premier module de commande (501) comprend : un premier déclencheur D (511), dans lequel une borne d'horloge du premier déclencheur D (511) est configurée pour recevoir le premier signal d'impulsion, une borne de réinitialisation du premier déclencheur D (511) est configurée pour recevoir un premier signal de réinitialisation, une borne d'entrée du premier déclencheur D (511) est configurée pour recevoir le signal d'entrée, et une borne de sortie du premier déclencheur D (511) est configurée pour sortir le premier signal d'ajustement ; ou
dans lequel le deuxième module de commande (502) comprend : un deuxième déclencheur D (512), dans lequel une borne d'horloge du deuxième déclencheur D (512) est configurée pour recevoir le deuxième signal d'impulsion, une borne de réinitialisation du deuxième déclencheur D (512) est configurée pour recevoir un deuxième signal de réinitialisation, une borne d'entrée du deuxième déclencheur D (512) est configurée pour recevoir le signal d'entrée, et une borne de sortie du deuxième déclencheur D (512) est connectée en série avec un onduleur et configurée pour émettre le deuxième signal d'ajustement à une sortie de l'onduleur.

10. Circuit (700) de sortie du signal retardé de la revendication 1, le circuit de sortie de signal (500) comprenant en outre : un nombre pair d'onduleurs, dans lequel les onduleurs sont connectés en série avec une borne de sortie du module de sortie de signal (503).

11. Circuit (700) de sortie du signal retardé de la revendication 1, dans lequel une période d'impulsion du premier signal d'impulsion est égale à une période d'impulsion du deuxième signal d'impulsion.

12. Circuit (700) de sortie du signal retardé de la revendication 1, dans lequel le premier module de commande (501) des circuits de sortie de signal (500) est en outre configuré pour recevoir un premier signal de commande, et le deuxième module de commande (502) des circuits de sortie de signal (500) est en outre configuré pour recevoir un deuxième signal de commande, et le premier signal de commande et le deuxième signal de commande sont des signaux inversés ;
chaque étage des circuits de sortie de signal (500) est configuré pour générer le signal de sortie retardé du circuit de sortie de signal d'étage actuel en fonction du premier signal de commande, du deuxième signal de commande, du premier signal d'impulsion, du deuxième signal d'impulsion et du signal de sortie retardé émis par le circuit de sortie de signal de l'étage précédent.

13. Circuit (700) de sortie du signal retardé de la revendication 1, comprenant en outre :
un circuit de sortie de signal initial (710) comprenant un premier module de commande (501), un deuxième module de commande (502) et un module de sortie de signal (503) ;
dans lequel le premier module de commande (501) du circuit de sortie de signal initial (710) est configuré pour recevoir le premier signal d'impulsion et un premier signal d'alimentation, et générer le premier signal d'ajustement en fonction du premier signal d'impulsion et du premier signal d'alimentation ;
le deuxième module de commande (502) du circuit de sortie de signal initial (710) est configuré pour recevoir le deuxième signal d'impulsion et un deuxième signal d'alimentation, et pour générer le deuxième signal d'ajustement en fonction du deuxième signal d'impulsion et du deuxième signal d'alimentation ;
le module de sortie de signal (503) du circuit de sortie de signal initial (710) est configuré pour générer le signal d'entrée initial en fonction du premier signal d'ajustement et du deuxième signal d'ajustement.
